# EUROPEAN PATENT APPLICATION

(11) **EP 4 760 722 A1**
(43) Date of publication of application: **17.06.2026**
(21) Application number: 24220148.1
(22) Date of filing: 16.12.2024
(51) Int. Cl.: G11C 11/16, G11C 11/56

(54) **MAGNETIC MEMORY CELL**

(71) Applicant: IMEC VZW, 3001 Leuven (BE)
(72) Inventor: CIUBOTARU, Florin, 3001 Leuven (BE); ADELMANN, Hanns Christoph, 3012 Wilsele (BE)
(74) Representative: Winger

(57) **Abstract**

A magnetic memory cell (100) includes a magnetic memory element (110) with at least one magnetic layer (111), configured to store information in distinct magnetization states. The magnetic layer (111) generates a stray magnetic field corresponding to its magnetization state. A magnetic field detection device (120) is positioned in proximity to the magnetic memory element (110) to detect variations in the stray magnetic field. The detection device (120) comprises a magnetostrictive (121) and piezoelectric (122) or a piezomagnetic (121) and piezoelectric (122) layer assembly. The magnetostrictive (121) or piezomagnetic (121) layer undergoes mechanical deformation in response to stray field changes, while the piezoelectric layer (122) generates an electrical signal representing the stored information. A writing mechanism (130) is configured to alter the magnetization state of the magnetic layer (111), enabling reliable data storage and retrieval.

## Description

### Field of the invention

The invention relates to the field of magnetic memory technologies. More specifically it relates to a memory reading mechanism for reading information stored in magnetic memory cells.

### Background of the invention

Magnetoresistive random access memory (MRAM) is a type of non-volatile memory that stores information in the magnetization state of a magnetic free layer within a magnetic tunnel junction (MTJ) stack. In an MRAM device, the writing process relies on a phenomenon known as the Spin-Transfer-Torque (STT) effect. A direct current (DC) flowing through the MTJ stack becomes spin-polarized as it passes through a fixed magnetic layer. This spin-polarized current exerts a torque on the magnetization of the free magnetic layer, causing it to switch between magnetization states depending on the polarization direction.

The magnetization states of the free and fixed magnetic layers can be aligned in parallel or anti-parallel configurations. These configurations correspond to two distinct resistance states of the MTJ, a low-resistance state and a high-resistance state, which define the binary memory states "0" and "1." The memory is read by determining the resistance state of the MTJ, typically using a tunneling magnetoresistance (TMR) effect.

While MRAM offers advantages such as non-volatility, speed, and endurance, the physical mechanism underlying its operation imposes certain limitations. Specifically, the reliance on the TMR effect and the binary nature of the resistance states restrict MRAM to storing only one bit of information per MTJ. This constraint has driven research into alternative architectures and methods to increase storage density and functionality within individual memory cells.

### Summary of the invention

It is an object of embodiments of the present invention to provide a magnetic memory cell comprising a good mechanism for reading information stored in the magnetic memory cell and to provide a method of operating such a memory cell.

The above objective is accomplished by a method and device according to the present invention.

In a first aspect embodiments of the present invention relate to a magnetic memory cell. The magnetic memory cell comprises a magnetic memory element with at least one magnetic layer. The magnetic layer is configured to store information in distinct magnetization states. It generates a stray magnetic field corresponding to the magnetization state of the stored information. The cell includes a magnetic field detection device positioned in proximity to the magnetic memory element, which detects variations in the stray magnetic field from the magnetic layer. The detection device consists of a magnetostrictive and piezoelectric layer assembly, or a piezomagnetic and piezoelectric layer assembly. The magnetostrictive or piezomagnetic layer undergoes mechanical deformation in response to changes in the stray magnetic field. The piezoelectric layer generates an electrical signal based on this deformation, representing the information stored in the magnetic memory element. The cell further includes a writing mechanism configured to alter the magnetization state of the magnetic layer.

It is an advantage of embodiments of the present invention that the magnetic field detection device, using a combination of magnetostrictive or piezomagnetic and piezoelectric layers, provides a more sensitive readout than conventional magnetoresistive-based detection. By responding directly to variations in stray magnetic fields, this setup enables higher sensitivity to magnetization states, allowing for more reliable detection, even at lower magnetic signal strengths.

In embodiments of the present invention the at least one magnetic layer has a perpendicular magnetic anisotropy.

It is an advantage of embodiments of the present invention that a perpendicular magnetic anisotropy is more advantageous for downscaling.

In embodiments of the present invention the magnetic memory element comprises a plurality of magnetic layers, separated by non-magnetic spacer layers. These magnetic layers are designed to store information in distinct magnetization states. The arrangement of the magnetic layers ensures that their stray fields, generated above the memory stack, either combine additively or partially compensate for one another. In embodiments of the present invention each magnetic layer has perpendicular magnetic anisotropy.

It is an advantage of embodiments of the present invention that the increased sensitivity readout design allows for multilayer configurations in the magnetic memory element. The multilayer option enables additional data density, as each layer can hold distinct magnetization states. The design's high sensitivity supports accurate readout of multilayer configurations, making it suitable for multibit storage.

In embodiments of the present invention a cumulative stray field is created with distinct levels corresponding to different magnetization configurations of the magnetic layers.

In embodiments of the present invention the writing mechanism is configured to individually alter the magnetization state of the one or more magnetic layers.

In embodiments of the present invention the magnetic field detection device comprises a thin-film transistor (TFT). A gate of the thin-film transistor is connected with a terminal of the piezoelectric layer such that a voltage over the piezoelectric layer controls the gate source voltage of the thin-film transistor.

It is an advantage of embodiments of the present invention that the thin-film transistor serves as an active amplification component, allowing small variations in the voltage generated by the piezoelectric layer in response to changes in the stray magnetic field to control a larger current through the transistor.

It is, moreover, an advantage of embodiments of the present invention that by integrating a thin-film transistor directly with the piezoelectric layer the need for complex sense amplifier circuitry is eliminated. The simpler and more compact thin-film transistor design allows for a smaller footprint, making it well-suited for high-density applications and reducing overall circuit complexity.

In embodiments the magnetic field detection device comprises a sense amplifier for amplifying a voltage over the piezoelectric layer.

It is an advantage of embodiments of the present invention that the sense amplifier amplifies the voltage generated by the piezoelectric layer thus increasing the sensitivity to changes in the stray magnetic field and therefore to changes in the magnetization states.

In embodiments of the present invention the writing mechanism comprises two terminals at outer ends of magnetic memory element for altering the magnetization state of the one or more magnetic layers.

It is an advantage of embodiments of the present invention that the placement of terminals at opposite ends of the memory element allows for efficient current flow across the magnetic layers, which is optimal for achieving the required spin-transfer torque (STT) or other current-based writing mechanisms.

In embodiments of the present invention the magnetic memory element comprises at least one polarizing layer.

In embodiments of the present invention the writing mechanism is configured to individually alter the magnetization state of the one or more magnetic layers by applying spin-transfer torque or voltage-controlled magnetic anisotropy or a combination of spin-transfer torque or voltage-controlled magnetic anisotropy.

In embodiments of the present invention the magnetic field detection device comprises the magnetostrictive and the piezoelectric layer and the magnetostrictive layer is a layer with in-plane anisotropy.

In embodiments of the present invention magnetic layers of the magnetic memory element are arranged such that their respective stray fields at the location of the magnetic field detection device stack are additive or partially compensating.

It is an advantage of embodiments of the present invention that a cumulative stray field with distinct levels corresponding to different magnetization configurations of the magnetic layers can be created.

In embodiments of the present invention the magnetic memory cell comprises a control circuit configured to adjust the voltage across the one or more magnetic layers for altering the magnetization state of the one or more magnetic layers.

In a second aspect embodiments of the present invention relate to a method of operating a magnetic memory cell. The method comprises:
- applying a control signal to a writing mechanism configured to alter the magnetization state of at least one magnetic layer within a magnetic memory element of the memory cell, wherein the magnetization state corresponds to the information to be stored,
- detecting variations in the stray magnetic field generated by the at least one magnetic layer using a magnetic field detection device comprising a magnetostrictive and piezoelectric or piezomagnetic and piezoelectric layer assembly,
- generating an electrical signal in response to the detected stray magnetic field via the piezoelectric layer, wherein the electrical signal represents the information stored in the magnetic memory element.

In embodiments of the present invention the control signal is applied to alter the magnetization state of multiple magnetic layers within the magnetic memory element, each separated by a non-magnetic spacer, resulting in distinct stray field levels based on the collective magnetization states of the magnetic layers, and wherein the distinct stray fields are detected by detecting the variations in the stray magnetic field to determine multi-bit information stored in the magnetic memory cell.

In embodiments of the present invention detecting the variations in the stray magnetic field comprises:
- inducing mechanical deformation in the magnetostrictive or piezomagnetic layer of the magnetic field detection device due to the stray field,
- converting the mechanical deformation into a voltage signal using the piezoelectric layer,
- amplifying the voltage signal with a sense amplifier or using the voltage signal to control a gate of a thin-film transistor.

In embodiments of the present invention the method comprises:
- configuring the writing mechanism to alter the magnetization state of the one or more magnetic layers by applying spin-transfer torque, voltage-controlled magnetic anisotropy (VCMA), or a combination of STT and VCMA,
- selectively adjusting the control signal to individually alter the magnetization states of the magnetic layers, enabling multi-level storage and retrieval of data in the magnetic memory cell.

Particular and preferred aspects of the invention are set out in the accompanying independent and dependent claims. Features from the dependent claims may be combined with features of the independent claims and with features of other dependent claims as appropriate and not merely as explicitly set out in the claims.

These and other aspects of the invention will be apparent from and elucidated with reference to the embodiment(s) described hereinafter.

### Brief description of the drawings

FIG. 1 shows a schematic drawing of a stack of a single-bit magnetic memory cell with magnetoelectric reading in accordance with embodiments of the present invention.
FIG. 2 shows a schematic drawing of a stack of a multi-bit magnetic memory cell with magnetoelectric reading in accordance with embodiments of the present invention.
FIG. 3 shows a schematic drawing of a stack of a single-bit magnetic memory cell with magnetoelectric reading with transistor integration in accordance with embodiments of the present invention.
FIG. 4 shows a schematic drawing of a stack of a multi-bit magnetic memory cell with magnetoelectric reading with transistor integration in accordance with embodiments of the present invention.
FIG. 5 shows the stray magnetic field of a memory cell that varies in discrete steps as different magnetic layers are switched up or down in accordance with embodiments of the present invention.
FIG. 6 shows a flow chart of an exemplary method in accordance with embodiments of the present invention.

Any reference signs in the claims shall not be construed as limiting the scope.
In the different drawings, the same reference signs refer to the same or analogous elements.

### Detailed description of illustrative embodiments

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

The terms first, second and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

Moreover, the terms top, under and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

In the description provided herein, numerous specific details are set forth. However, it is understood that embodiments of the invention may be practiced without these specific details. In other instances, well-known methods, structures and techniques have not been shown in detail in order not to obscure an understanding of this description.

Where in embodiments of the present invention reference is made to a magnetic field detection device which is arranged in proximity to the magnetic memory element reference is made to a field detection device which is arranged close enough to the magnetic memory element for detecting the stray fields using a magnetostrictive and a piezoelectric or a piezomagnetic and a piezoelectric layer assembly. It is thereby noted that the stray field decrease with the distance (proportional with 1/d³).

The present invention relates to a magnetic memory cell that enables efficient storage and retrieval of information by employing a novel architecture that supports multi-bit storage within a single device. We propose a scheme where several magnetic layers, forming a memory stack, can be used to store more than one bit of information. This is achieved by designing the memory element to generate stray magnetic fields that correspond to distinct magnetization states of the individual magnetic layers, allowing for multilevel information representation.

The reading mechanism is based on the generation of charge or voltage through the inverse magnetoelectric effect in magnetostrictive/piezoelectric or piezomagnetic/piezoelectric composites. This approach utilizes a magnetic field detection device positioned in proximity to the memory stack, which detects variations in the stray magnetic field. The detection device converts these magnetic field variations into electrical signals through the mechanical deformation of the magnetostrictive or piezomagnetic layer, coupled with the piezoelectric layer. This mechanism offers the potential for reduced energy consumption during the readout process compared to conventional methods.

The magnetic memory cell further comprises a writing mechanism designed to alter the magnetization state of the magnetic layers. This enables precise control over the stored information, facilitating the implementation of high-density, energy-efficient memory devices. The invention provides a significant step forward in magnetic memory technologies, addressing limitations of conventional architectures and enabling new applications in data storage and processing.

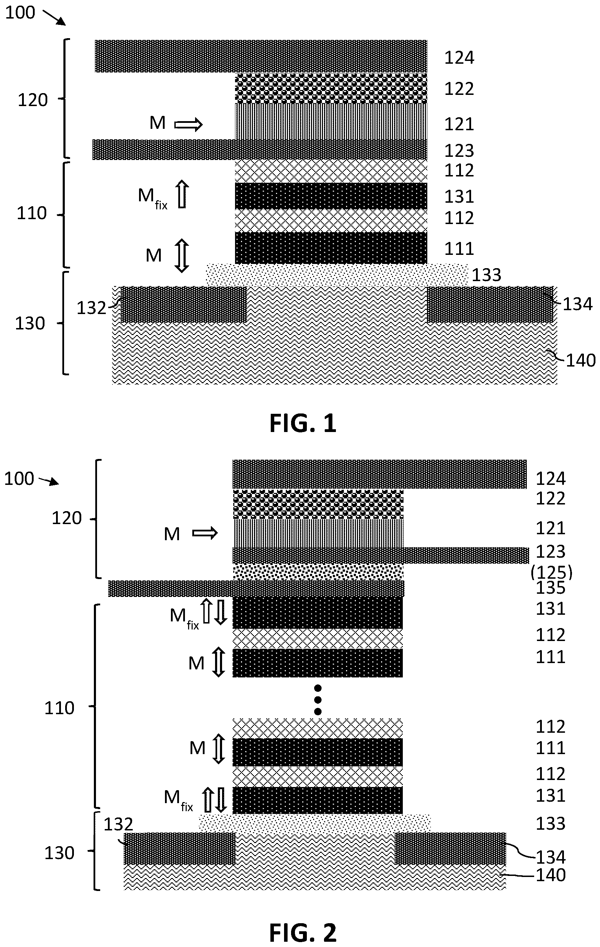

In a first aspect, embodiments of the present invention relate to a magnetic memory cell (100) comprising a magnetic memory element (110), a magnetic field detection device (120), and a writing mechanism (130). Exemplary stacks of such a device are shown in FIG. 1 to FIG. 4. In FIG. 1 to FIG. 4, the stacks of the magnetic memory cells are built on a substrate (140)

The magnetic memory element (110) includes at least one magnetic layer (111) configured to store information in distinct magnetization states. These magnetization states generate a stray magnetic field corresponding to the stored information. The magnetic layer may exhibit perpendicular magnetic anisotropy.

In case of a magnetostrictive layer the magnetization of the magnetostrictive layer, which exhibits in-plane anisotropy, rotates in response to the stray fields from the memory stack. This rotation induces mechanical stress in the magnetostrictive layer, which is transferred to the piezoelectric layer. The stress in the piezoelectric layer generates a charge separation and an electrical voltage that can be measured across a pair of electrodes (123), (124) (see the exemplary embodiments of FIG. 1 to FIG. 4). This voltage corresponds to the magnetization state and allows for precise determination of the memory level.

In case of a piezomagnetic layer the up or down orientation of the magnetization in the piezomagnetic layer generates stress, which is transferred to the piezoelectric layer, resulting in voltage generation. This approach can further expand the number of distinguishable memory levels by leveraging the unique responses of the piezomagnetic/piezoelectric composites to varying stray field strengths.

The magnetic field detection device (120) is arranged in proximity to the magnetic memory element (110) to detect variations in the stray magnetic field. The detection device comprises a magnetostrictive (121) and piezoelectric (122) layer assembly or, alternatively, a piezomagnetic (121) and piezoelectric (122) layer assembly. Changes in the stray magnetic field induce mechanical deformation in the magnetostrictive or piezomagnetic layer, which is converted into an electrical signal by the piezoelectric layer. This electrical signal represents the information stored in the magnetic memory element and facilitates the readout process.

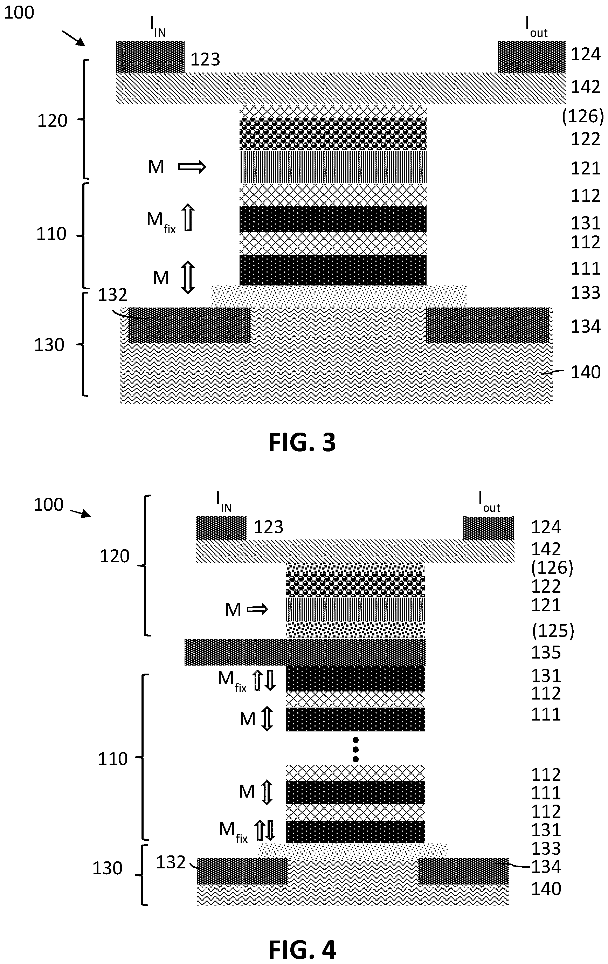

Embodiments of the present invention may extend to multi-bit storage within a single magnetic memory cell. This is achieved by utilizing multiple magnetic layers (111) within the magnetic memory element (110), separated by non-magnetic spacer layers. Each magnetic layer stores information in distinct magnetization states, and their respective stray magnetic fields interact additively or partially compensate to create discrete field levels detectable by the magnetic field detection device (120). Such a configuration enables the storage of multiple bits of information in a single memory device, as illustrated in FIG. 2 and FIG. 4.

The writing mechanism (130) is configured to alter the magnetization state of the one or more magnetic layers (111), enabling the writing or updating of information within the memory cell. This mechanism can utilize a two-terminal configuration based on Spin-Transfer Torque (STT), employing one or multiple fixed magnetic layers as polarizers with different magnetic orientations. Alternatively, the writing process may involve Voltage-Controlled Magnetic Anisotropy (VCMA) or a combination of STT and VCMA, depending on the specific memory cell configuration.

In embodiments of the present invention the writing mechanism (130) comprises two terminals at outer ends of magnetic memory element (110) for altering the magnetization state of the one or more magnetic layers (111).

Two terminals (132, 134) may be present at outer ends of an SOT track (133). Where in embodiments of the present invention reference is made to an SOT track, reference is made to a conductive layer composed of a material with strong spin-orbit coupling properties, such as a heavy metal, topological insulator, or similar material. This layer is configured to generate a spin current via the spin Hall effect or Rashba effect when a charge current is applied, and this spin current is used to exert a torque on the magnetization of an adjacent magnetic layer to alter its state. Examples thereof are shown in FIG. 1 to FIG. 4.

More advanced writing schemes, such as those combining STT with Spin-Orbit Torque (SOT) or Voltage-Gated SOT (VG-SOT), are also possible. However, these architectures generally require additional electrical terminals, increasing complexity.

In embodiments of the present invention, the writing mechanism is similar to those used in magnetic tunnel junction MRAM technologies, with spatial density being influenced by the coupling or magnetic field interactions with neighbouring devices. This ensures compatibility with existing fabrication processes while maintaining the scalability and functionality of the memory cell.

In embodiments of the present invention the magnetic memory element comprises at least one polarizing layer (131). It is an advantage of embodiments of the present invention that when an electric current flows through the polarizing layer a stream of electrons with spins aligned in a specific direction is obtained. This allows to use STT as writing mechanism for altering the magnetization state of the at least one magnetic layer.

In embodiments of the present invention, such as illustrated in FIG. 1 to FIG. 4, terminals (132) and (134) are positioned at the outer ends of an SOT track, allowing a charge current to flow through the track.

In embodiments of the present invention a polarizing layer (131) may be positioned adjacent to the SOT track, which serves to polarize the spin current. This polarizing layer is a fixed magnetic layer with a stable magnetization direction, ensuring that the spin current generated by the SOT track is effectively polarized before interacting with the magnetic memory element.

In embodiments of the present invention the magnetic layers may be written by flowing a current through the stack. This current may for example be applied between electrodes at outer ends of the stack (electrode (123) at one end of the stack and electrode (132) or (134) at the opposite end of the stack). In this case the writing mechanism is based on STT and polarizer layers (131) are needed. More than one polarizing layer (131) may be applied to allow for more combinations/bits. In such embodiments the SOT track (133) is not needed and only a single bottom electrode (132 or 134) is required.

In embodiments of the present invention layers of the memory element may be written using STT and a top polarizing layer. In such embodiments a bottom polarizing layer (131) is not required. In such embodiments layers of the memory element are written using STT and the top Polarizer, whereas the SOT track will write the bottom magnetic layer as in FIG.1. For such embodiments, a stack as shown in FIG. 2 should be modified such that the bottom magnetic layer (111) is positioned directly on top of the SOT track (133).

An example of a writing mechanism (130) with three terminals is illustrated in FIG. 2 and FIG. 4. The writing mechanism may utilize Spin-Transfer Torque (STT), Voltage-Controlled Magnetic Anisotropy (VCMA), or Spin-Orbit Torque (SOT) to alter the magnetization state of the magnetic layers within the magnetic memory element. The writing process involves the application of electrical signals through specific terminals configured for these mechanisms.

Adjacent to the polarizing layer (131) is a non-magnetic spacer layer (112). This layer decouples the polarizing layer from the adjacent magnetic layer, preventing direct magnetic coupling while allowing the spin-polarized current to transfer efficiently through the stack.

Adjacent to the non-magnetic spacer layer (112) is the magnetic layer (111), which serves as the storage element of the memory cell. The magnetization state of this layer is altered by the spin current generated by the SOT track and polarized by the polarizing layer. This configuration allows precise control of the magnetization state of the magnetic layer, enabling reliable writing operations.

The stack illustrated in FIG. 2 and FIG. 4 comprises a plurality of stacked non-magnetic spacer layers (112) and magnetic layers (111), arranged alternately to form a multilayer structure. Each magnetic layer (111) is separated by a non-magnetic spacer layer (112), which prevents direct magnetic coupling between adjacent magnetic layers while enabling efficient interaction via stray fields or spin-polarized currents.

On top of the stack, a second polarizing layer (131) is provided. This layer functions as an additional fixed magnetic layer with a stable magnetization direction, complementing the first polarizing layer (131) positioned adjacent to the SOT track at the base of the stack. The second polarizing layer enhances the control over spin polarization and stray field interactions, contributing to improved readout accuracy and multi-bit storage capability.

In addition to terminals (132) and (134), a terminal (135) is positioned on the opposite side of the magnetic memory element compared to terminals (132) and (134). This terminal facilitates the application of a voltage or current for mechanisms like STT or VCMA, providing another control point for altering the magnetization state of the magnetic layers.

A polarizing layer is not strictly required. It is for example not required in the case of one single layer and spin orbit torque as writing mechanism. In a spin orbit torque based memory cell, a heavy metal layer is placed adjacent to the magnetic storage layer. When a charge current is passed through the heavy metal layer, the spin Hall effect generates a transverse spin current (perpendicular to the charge current). This spin current accumulates at the interface with the magnetic layer, producing a torque on its magnetization. This torque can switch the magnetization direction (up or down) depending on the polarity and magnitude of the applied current. This switching represents the data being written (a binary 0 or 1).

In embodiments of the present invention, the magnetic memory element (110) and the magnetic field detection device (120) are arranged in a vertical arrangement to optimize the compactness and efficiency of the memory cell (100) design. In this configuration, the magnetic memory element (110), comprising one or more magnetic layers (111) separated by non-magnetic spacer layers (112), is positioned directly beneath the magnetic field detection device (120).

This vertical stacking enables the stray magnetic fields generated by the magnetic memory element (110) to propagate upwards directly to the magnetic field detection device (120) without significant loss of field strength. The proximity between the components ensures that the detection device (120), which includes a magnetostrictive (121) and piezoelectric (122) or piezomagnetic (121) and piezoelectric (122) layer assembly, can accurately and efficiently detect variations in the stray magnetic field corresponding to the magnetization states of the memory layers (111).

The vertical arrangement also facilitates efficient integration of the memory cell (100) into larger arrays, as it minimizes the lateral footprint of each cell. This design is particularly advantageous for high-density memory applications, where space optimization is critical. Moreover, the vertical arrangement allows for precise alignment of the detection device (120) with the memory element (110), enhancing the reliability of the readout process while reducing energy consumption and signal interference.

The spacer layers (112) used in the magnetic memory element (110) of the present invention may comprise non-magnetic metals or oxides.

In embodiments of the present invention, such as illustrated in FIG. 3 and FIG. 4, a thin-film transistor (142) is integrated into the magnetic field detection device (120) to enhance readout functionality. The thin-film transistor (142) provides signal amplification and facilitates efficient electrical interfacing with external circuitry.

The gate of the thin-film transistor (142) is electrically connected to a terminal of the piezoelectric layer (122). This connection enables the voltage generated across the piezoelectric layer (122) in response to mechanical deformation to control the gate-source voltage of the thin-film transistor (142). This configuration ensures accurate signal transfer from the detection device to the output circuitry.

Contacts Iᵢₙ (123) and Iₒᵤₜ (124) are provided for interfacing with the input and output terminals of the thin-film transistor (142), allowing the amplified electrical signal to be processed further.

Optionally, in the embodiment illustrated in FIG. 2, an insulator (125) may be positioned between the memory element (110) and the detection device (120) for electrically decoupling the writing part (voltages-currents applied to write the memory element) and the reading voltage for the output between the pair of electrodes (123, 124).

Optionally, in the embodiment illustrated in FIG. 4, the insulator (125) may be positioned between the magnetostrictive or piezomagnetic layer (121) and a terminal (135) of the writing mechanism (130).

Optionally, in the embodiments illustrated in FIG. 3 and FIG. 4, an insulator (126) may be positioned between the thin-film transistor (142) and the piezoelectric layer (122). This insulator layer (126) does not change the accumulated charge at the piezoelectric layer (122) but may be advantageous for the integration of the different layers and for reducing leakage.

The integration of the TFT within the detection device (120) adds several advantages. It simplifies signal amplification by embedding it directly in the memory cell structure, reducing the need for external amplifiers. Furthermore, as seen in FIG. 3, this configuration is particularly effective for single-bit readout applications, while FIG. 4 demonstrates its scalability and utility in multi-bit memory cells, where the detection device (120) reads varying stray field levels from multiple magnetic layers (111) within the memory element (110).

This arrangement ensures a compact and energy-efficient design, as the direct connection between the piezoelectric layer (122) and the TFT minimizes signal loss and interference. Additionally, the TFT integration facilitates seamless compatibility with modern semiconductor fabrication processes, making it highly suitable for high-density memory applications.

In embodiments of the present invention the magnetic field detection device (120) may comprise a sense amplifier for amplifying a voltage over the piezoelectric layer (122).

The overall magnetic memory stack generates a magnetic stray field, the magnitude of which is determined by the relative orientation (up or down) of the magnetization in the individual memory layers. As each magnetic layer switches its magnetization state, the stray field changes in discrete steps, providing a distinct signal for each configuration of the memory layers. This stepwise variation in the stray field is a key feature of the multilevel memory cell, allowing it to store multiple bits of information.

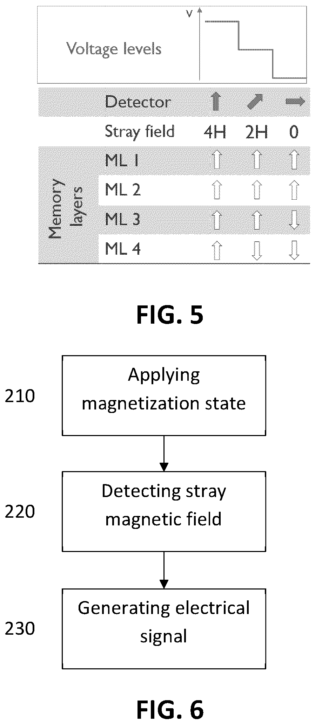

It is noteworthy that the memory layers can be designed such that their stray fields either fully or partially compensate each other at the position of the magnetic field detection device. This design flexibility enables precise control over the stray field strength, improving the readout accuracy and efficiency of the detection device while minimizing interference from unwanted magnetic field components. FIG. 5 illustrates the magnetic stray field produced by the overall magnetic memory stack, showing how the stray field varies in discrete steps as the magnetization states of the individual memory layers are switched up or down. The diagram demonstrates the stepwise nature of the stray field changes and highlights the potential for full or partial compensation of the stray fields at the detector position, depending on the relative orientation of the magnetization in the memory layers.

In embodiments of the present invention the magnetic memory cell (100) includes a control circuit designed to manage the voltage applied between terminals at outer ends of a magnetic memory element (110). This may be between terminals (132, 134) at outer ends of an SOT track (133) or between terminals (135, 132 or 134) at opposite ends of the stack of layers of the magnetic memory element (110). This control circuit facilitates the adjustment of the magnetization state of the magnetic layers, enabling reliable write operations within the memory cell. Such a control circuit may for example comprise a voltage controlled current source, or a Digital-to-Analog converter.

In a second aspect, embodiments of the present invention relate to a method (200) of operating a magnetic memory cell (100) in accordance with embodiments of the present invention. The method (200) comprises multiple steps to write, detect, and read stored information. This method ensures efficient and accurate operation of the magnetic memory cell by leveraging advanced writing and detection mechanisms.

In a first step, a control signal is applied (210) to a writing mechanism (130) that is configured to alter the magnetization state of at least one magnetic layer (111) within the magnetic memory element (110). The magnetization state corresponds to the information to be stored, allowing precise and reliable data encoding in the memory cell.

The next step involves detecting variations (220) in the stray magnetic field generated by the magnetization state of the at least one magnetic layer (111). This detection is performed using a magnetic field detection device (120) comprising a magnetostrictive (121) and piezoelectric (122) layer assembly or, alternatively, a piezomagnetic (121) and piezoelectric (122) layer assembly. The detection process captures the changes in the stray field corresponding to the stored information.

Following detection, an electrical signal is generated (230) in response to the detected stray magnetic field. This signal is produced by the piezoelectric layer (122) and represents the information stored in the magnetic memory element (110). The generated signal serves as the basis for reading the stored data.

In embodiments of the present invention, the method involves applying the control signal (210) to alter the magnetization states of multiple magnetic layers (111) within the magnetic memory element (110). These layers are separated by non-magnetic spacer layers (112) and configured to collectively generate distinct stray field levels. By detecting (220) the variations in the stray magnetic field, the method enables the determination of multi-bit information stored in the memory cell (100).

In embodiments of the present invention, detecting variations in the stray magnetic field (220) comprises inducing mechanical deformation in the magnetostrictive (121) or piezomagnetic (121) layer of the magnetic field detection device (120) due to the stray field. This mechanical deformation is then converted into a voltage signal using the piezoelectric layer (122). The resulting voltage signal may be amplified using a sense amplifier or used to control the gate of a thin-film transistor (142), ensuring accurate and efficient data readout.

In embodiments of the present invention the method comprises configuring the writing mechanism (130) to alter the magnetization states of one or more magnetic layers (111) using Spin-Transfer Torque (STT), Voltage-Controlled Magnetic Anisotropy (VCMA), or a combination of these mechanisms. The control signal can be selectively adjusted to individually alter the magnetization states of the magnetic layers, enabling multi-level storage of data within the magnetic memory cell (100). Multi-level retrieval of data within the magnetic memory cell is enabled by detecting (220) the variations in the stray magnetic field using a magnetic field detection device (120) comprising a magnetostrictive (121) and piezoelectric (122) or piezomagnetic (121) and piezoelectric (122) layer assembly. This selective control and detection ensures flexible and scalable operation, making the memory cell suitable for high-density storage applications.

The stack in FIG. 1, showing single-bit SOT in combination with reading using a magnet field detection device in accordance with embodiments of the present invention, comprises the following layers from top to bottom:
- 124: Electrode for detection device.
- 122: Piezoelectric layer for voltage generation.
- 121: Magnetostrictive or piezomagnetic layer that deforms in response to stray magnetic fields.
- 123: Electrode for the detection device.
- 112: Non-magnetic spacer layer.
- 131: Polarizing layer to polarize the spin current.
- 112: Non-magnetic spacer layer.
- 111: Magnetic layer for storing information.
- 133: SOT track for generating spin currents.
- 132, 134: Terminals for applying current through the SOT track for writing mechanism.
- 140: Substrate providing mechanical support and integration.

The stack in FIG. 2, showing multibit SOT in combination with reading using a magnetic field detection device in accordance with embodiments of the present invention, comprises the following layers from top to bottom:
- 124: Electrode for detection device.
- 122: Piezoelectric layer for voltage generation.
- 121: Magnetostrictive or piezomagnetic layer that deforms in response to stray magnetic fields.
- 123: Electrode for the detection device.
- 125: Optional insulator.
- 135: Terminal for writing mechanism.
- 131: Polarizing layer to polarize the spin current.
- 112: Non-magnetic spacer layer.
- 111: Magnetic layer for storing information.
- Additional alternating layers of non-magnetic spacer layers (112) and magnetic layers (111).
- 131: Polarizing layer at the bottom of the stack.
- 133: SOT track for generating spin currents.
- 132, 134: Terminals for applying current through the SOT track for writing mechanism.
- 140: Substrate providing mechanical support and integration.

The stack in FIG. 3, showing single-bit SOT in combination with reading using a thin-film transistor and magnetic field detection device in accordance with embodiments of the present invention, comprises the following layers from top to bottom:
- 123: Electrode for the detection device.
- 124: Electrode for detection device.
- 142: Thin-film transistor for signal amplification.
- 126: Optional insulator.
- 122: Piezoelectric layer for voltage generation.
- 121: Magnetostrictive or piezomagnetic layer that deforms in response to stray magnetic fields.
- 112: Non-magnetic spacer layer.
- 131: Polarizing layer to polarize the spin current.
- 112: Non-magnetic spacer layer.
- 111: Magnetic layer for storing information.
- 133: SOT track for generating spin currents.
- 132, 134: Terminals for applying current through the SOT track for writing mechanism.
- 140: Substrate providing mechanical support and integration.

The stack in FIG. 4, showing multibit SOT in combination with reading using a thin-film transistor and magnetic field detection device in accordance with embodiments of the present invention, comprises the following layers from top to bottom:
- 123: Electrode for the detection device.
- 124: Electrode for the detection device.
- 142: Thin-film transistor for signal amplification.
- 126: Optional insulator.
- 122: Piezoelectric layer for voltage generation.
- 121: Magnetostrictive or piezomagnetic layer that deforms in response to stray magnetic fields.
- 125: Optional insulator.
- 135: Terminal for writing mechanism.
- 131: Polarizing layer to polarize the spin current.
- 112: Non-magnetic spacer layer.
- 111: Magnetic layer for storing information.
- Additional alternating layers of non-magnetic spacer layers (112) and magnetic layers (111).
- 131: Polarizing layer at the bottom of the stack.
- 133: SOT track for generating spin currents.
- 132, 134: Terminals for applying current through the SOT track for writing mechanism.
- 140: Substrate providing mechanical support and integration.

## Claims

1. A magnetic memory cell (100) comprising:
- a magnetic memory element (110) with at least one magnetic layer (111), configured to store information in distinct magnetization states, the at least one magnetic layer (111) generating a stray magnetic field corresponding to the magnetization state of the stored information,
- a magnetic field detection device (120) positioned in proximity to the magnetic memory element (110) and configured to detect variations in the stray magnetic field from the at least one magnetic memory element, the magnetic field detection device (120) comprising: a magnetostrictive (121) and a piezoelectric (122) or a piezomagnetic (121) and a piezoelectric (122) layer assembly, wherein the magnetostrictive (121) or piezomagnetic (121) layer undergoes mechanical deformation in response to changes in the stray magnetic field, and the piezoelectric layer (122) generates an electrical signal based on this deformation, said signal representing the information stored in the magnetic memory element,
- a writing mechanism (130) configured to alter the magnetization state of the at least one magnetic layer.

2. The magnetic memory cell (100) according to claim 1, wherein the at least one magnetic layer has a perpendicular magnetic anisotropy.

3. The magnetic memory cell (100) according to any of the previous claims wherein the magnetic memory element (110) comprises a plurality of magnetic layers (111) separated by non-magnetic spacer layers (112), each magnetic layer configured to store information in distinct magnetization states, wherein the magnetic layers (111) are arranged such that their respective stray fields above the memory stack are additive or partially compensating.

4. The magnetic memory cell (100) according to any of the previous claims wherein the magnetic field detection device (120) comprises a thin-film transistor (142), wherein a gate of the thin-film transistor (142) is connected with a terminal of the piezoelectric layer (122) such that a voltage over the piezoelectric layer (122) controls the gate source voltage of the thin-film transistor (142).

5. The magnetic memory cell (100) according to any of the claims 1 to 3 wherein the magnetic field detection device (120) comprises a sense amplifier for amplifying a voltage over the piezoelectric layer (122).

6. The magnetic memory cell (100) according to any of the previous claims wherein the writing mechanism (130) comprises two terminals (132, 134, 135) at outer ends of magnetic memory element (110) for altering the magnetization state of the one or more magnetic layers (111).

7. The magnetic memory cell (100) according to claim 3 wherein the magnetic memory element comprises at least one polarizing layer (131).

8. The magnetic memory cell (100) according to any of the previous claims wherein the writing mechanism (130) is configured to individually alter the magnetization state of the one or more magnetic layers (111) by applying spin-transfer torque or voltage-controlled magnetic anisotropy or a combination of spin-transfer torque or voltage-controlled magnetic anisotropy.

9. The magnetic memory cell (100) according to any of the previous claims wherein the magnetic field detection device (120) comprises the magnetostrictive (121) and the piezoelectric (122) layer and wherein the magnetostrictive (121) layer is a layer with in-plane anisotropy.

10. The magnetic memory cell (100) according to any of the previous claims as long as dependent on claim 2, wherein the magnetic layers (111) of the magnetic memory element (110) are arranged such that their respective stray fields at the location of the magnetic field detection device (120) stack are additive or partially compensating.

11. The magnetic memory cell (100) according to any of the previous claims comprising a control circuit configured to adjust the voltage across the one or more magnetic layers (111) for altering the magnetization state of the one or more magnetic layers (111).

12. A method (200) of operating a magnetic memory cell (100), the method (200) comprising:
- applying (210) a control signal to a writing mechanism (130) configured to alter the magnetization state of at least one magnetic layer (111) within a magnetic memory element (110) of the memory cell (100), wherein the magnetization state corresponds to the information to be stored,
- detecting (220) variations in the stray magnetic field generated by the at least one magnetic layer (111) using a magnetic field detection device (120) comprising a magnetostrictive (121) and piezoelectric (122) or piezomagnetic (121) and piezoelectric (122) layer assembly,
- generating (230) an electrical signal in response to the detected stray magnetic field via the piezoelectric layer (122), wherein the electrical signal represents the information stored in the magnetic memory element (110).

13. The method (200) according to claim 12, wherein the control signal is applied (210) to alter the magnetization state of multiple magnetic layers (111) within the magnetic memory element (110), each separated by a non-magnetic spacer (112), resulting in distinct stray field levels based on the collective magnetization states of the magnetic layers (111), and wherein the distinct stray fields are detected by detecting (220) the variations in the stray magnetic field to determine multi-bit information stored in the magnetic memory cell (100).

14. The method (200) according to claim 12 or 13, wherein detecting (220) the variations in the stray magnetic field comprises:
- inducing mechanical deformation in the magnetostrictive (121) or piezomagnetic (121) layer of the magnetic field detection device (120) due to the stray field,
- converting the mechanical deformation into a voltage signal using the piezoelectric layer (122),
amplifying the voltage signal with a sense amplifier or using the voltage signal to control a gate of a thin-film transistor (142).

15. The method (200) according to any of claims 12 to 14, further comprising:
- configuring the writing mechanism (130) to alter the magnetization state of the one or more magnetic layers (111) by applying spin-transfer torque (STT), voltage-controlled magnetic anisotropy (VCMA), or a combination of STT and VCMA,
- selectively adjusting the control signal to individually alter the magnetization states of the magnetic layers (111), enabling multi-level storage and retrieval of data in the magnetic memory cell (100).
